# EUROPÄISCHE PATENTSCHRIFT

(11) **EP 4 296 696 B1**
(45) Veröffentlichungstag und Bekanntmachung des Hinweises auf die Patenterteilung: **18.06.2025**
(21) Anmeldenummer: 22180364.6
(22) Anmeldetag: 22.06.2022
(51) Int. Cl.: G01R 19/165, H01H 71/02, H01H 71/04

(54) **MESSMODUL**
MEASURING MODULE
MODULE DE MESURE

(43) Veröffentlichungstag der Anmeldung: 27.12.2023
(73) Patentinhaber: K & N Schalterentwicklungsgesellschaft m.b.H., 1180 Wien (AT)
(72) Erfinder: Konrad, Andreas, 1030 Wien (AT); Hofer, Andreas, 8241 Limbach (AT)
(74) Vertreter: KLIMENT & HENHAPEL

(56) Entgegenhaltungen:
- EP-A1- 2 282 321
- EP-A1- 2 927 928
- EP-A1- 3 637 355
- DE-A1- 102005 025 541
- DE-U1- 202016 103 410
- US-A1- 2015 070 026

## Beschreibung

### GEBIET DER ERFINDUNG

Die Erfindung betrifft ein Messmodul zum Messen zumindest einer Messgröße in einem Niederspannungsnetz, wobei das Messmodul ein Modulgehäuse, zumindest einen Phasenkontakt zum Anschließen an jeweils einen Außenleiter sowie zumindest einen Messsensor zum Erfassen zumindest einer dem jeweiligen Außenleiter zuzurechnenden Messgröße umfasst, und wobei für jeden Phasenkontakt jeweils zumindest ein Funktionsindikator vorgesehen ist, wobei der jeweilige zumindest eine Funktionsindikator am Modulgehäuse angeordnet ist, und wobei das Messmodul dazu eingerichtet ist, den jeweiligen zumindest einen Funktionsindikator in Abhängigkeit von der zumindest einen erfassten Messgröße anzusteuern und wahlweise ein Überschreiten oder ein Unterschreiten zumindest eines Grenzwerts der zumindest einen zu erfassenden Messgröße als Fehlersignal mittels des jeweiligen zumindest einen Funktionsindikators anzuzeigen.

Überdies werden im Rahmen der Erfindung eine Messeinrichtung mit zumindest einem Messmodul sowie mit einem Kommunikationsmodul, und weiters ein Messsystem mit zumindest einem Messmodul oder mit einer Messeinrichtung sowie mit einem Lasttrennschalter angegeben.

### STAND DER TECHNIK

Aus dem Stand der Technik sind bereits eine Vielzahl an Ausführungsformen von Messmodulen bekannt geworden, die zum Messen des in einem Leiter eines Niederspannungsverteilers fließenden Stroms vorgesehen sind.

Nachteilig ist bei zahlreichen bisher bekannt gewordenen Messmodulen jedoch, dass eine Funktionsanzeige, die an einem herkömmlichen Messmodul üblicherweise in Form eines optischen und/oder akustischen Signals vorgesehen sein kann, meist nur den Status des gesamten Messmoduls oder eine bestimmte Funktion mit einer festgelegten Messgröße anzeigt. So kann beispielsweise bei einem solchen Messmodul eine Funktionsanzeige für die Phasenüberwachung vorgesehen sein, wobei bei einem Phasenausfall oder einer Spannungsasymmetrie im Niederspannungsnetz die Funktionsanzeige aktiviert wird und daraufhin vom Messmodul beispielsweise das Ausschalten der Spannungsversorgung eines Gerätes oder eines Niederspannungsverteilers veranlasst wird.

Weiters sind aus dem Stand der Technik Messmodule bekannt, die gewissermaßen nur zur Erfassung einer Messgröße, beispielsweise der Spannung, vorgesehen sind, wobei geprüft wird, ob an allen Außenleitern Spannung anliegt. Zu diesem Zweck kann für jeden Außenleiter jeweils ein Indikator vorgesehen sein.

Überdies gibt es bereits Messgeräte, mit denen zwar unterschiedliche Messgrößen bestimmbar und darstellbar sind, was allerdings mit Aufwand verbunden sowie fehleranfällig ist, weil dazu üblicherweise Anzeigedisplays von einem Benutzer exakt abgelesen werden müssen. Insbesondere kann ein Benutzer bei der Verwendung solcher Messgeräte nicht auf einen Blick erkennen, ob ein aktuell angezeigter Messwert einer erfassten Messgröße im Rahmen bestimmter Grenzwerte bzw. Schwellenwerte der erfassten Messgröße liegt, wobei die Grenzwerte bzw. Schwellenwerte entsprechend der jeweiligen Messaufgabe einstellbar sein sollen.

Definitionsgemäß handelt es sich beim umgangssprachlich gebräuchlichen Begriff einer "Phase" um einen Außenleiter. Ein Außenleiter ist ein Leiter, der im üblichen elektrischen Betrieb unter Spannung steht und zur Übertragung oder Verteilung elektrischer Energie beitragen kann, aber kein Neutralleiter bzw. kein Mittelleiter ist. Bei einphasigen Anschlüssen mit einer Nennspannung beispielsweise von 230 V tritt ein Außenleiter nur einfach auf und wird üblicherweise mit dem Buchstaben L (vom englischen Begriff: line conductor) bezeichnet. Bei Dreiphasenanschlüssen gibt es demnach drei Außenleiter, die üblicherweise mit L1, L2 und L3 bezeichnet werden. Dabei handelt es sich um drei Leiter mit um je 120° phasenverschobener Wechselspannung im Drehstromsystem. In der Regel sind sowohl die Außenleiter wie auch der Neutralleiter stromführend, wobei zwischen den Außenleitern eine effektive Spannung von üblicherweise 400 V anliegt. Im Folgenden werden die beiden Begriffe "Außenleiter" und "Phase" gleichwertig nebeneinander verwendet.

Die EP 3637355A1 offenbart ein anzeigenloses Modul zur Überwachung elektrischer Parameter, vorzugsweise von Strömen, in einem Schaltschrank. Darüber hinaus umfasst das Modul statt einer Anzeige ein Kommunikationsterminal sowie einen internen Speicher für gemessene Daten. Alle funktionalen Teile des Moduls sind auf einer Leiterplatte (PCB, printed circuit board) ausgeführt.

Die EP 2282321A1 offenbart ein Modul zum Messen des in einem Leiter eines Niederspannungsverteilers fließenden Stroms. Es umfasst einen Stromsensor und eine Mikroprozessorschaltung und ist hinsichtlich seiner äußeren Form so ausgebildet, dass es in einen Niederspannungsverteiler einbaubar ist. Der gemessene Strom wird dabei von einer Mehrzahl an Leuchtdioden codiert angezeigt, wobei jede Leuchtdiode einem fest vorgegebenen, nicht verstellbaren, Prozentsatz eines Maximalstroms entspricht.

Die US 2015/070026A1 offenbart ein Verfahren zur Überwachung von Stromstärken, Spannungen, Leistung und Temperatur in einem elektrischen Stromkreis und zur allfälligen Abschaltung des überwachten Stromkreises. Die ermittelten Daten werden über eine drahtlose Datenverbindung zu einer Datenverarbeitungseinheit gesendet. Werden Grenzparameter überschritten, so wird dies nicht frontal angezeigt, sondern wird eine Abschaltung des überwachten Stromkreises ausgeführt.

Die DE 102005025541A1 offenbart eine Steckdose, welche einen Stromsensor umfasst, mit welchem ausschließlich der Stromfluss im von der Steckdose gespeisten Stromkreis überwacht wird.

### AUFGABE DER ERFINDUNG

Es ist daher eine Aufgabe der Erfindung, die Nachteile des Stands der Technik zu überwinden und ein Messmodul vorzuschlagen, bei dem unterschiedliche Messgrößen insbesondere phasenweise gemäß ihren jeweils aktuellen Messwerten angezeigt werden können, und zwar so, dass für einen Benutzer rasch und fehlerfrei erkennbar ist, ob ein aktuell angezeigter Messwert einer erfassten Messgröße im Rahmen bestimmter Grenzwerte bzw. Schwellenwerte der erfassten Messgröße liegt.

Eine weitere Aufgabe der Erfindung besteht darin, ein Messmodul anzugeben, das benutzerfreundlich ist, wobei ein Benutzer rasch, vorzugsweise auf einen Blick, Überprüfungen und/oder Änderungen der Einstellungen des Messmoduls, insbesondere Einstellungen betreffend individuelle Grenzwerte bzw. Schwellenwerte zu erfassender Messgrößen, vornehmen können soll. Weiters sollen die vom Messmodul erfassten Messdaten rasch auslesbar sein.

### DARSTELLUNG DER ERFINDUNG

Diese Aufgabe wird erfindungsgemäß mit einem Messmodul gemäß Anspruch 1 gelöst.

Ein einzelner Außenleiter, der dem zumindest einen Phasenkontakt zugeordnet ist bzw. der an einen bestimmten Phasenkontakt angeschlossen ist, dient insbesondere dabei jeweils zumindest abschnittsweise als "Messobjekt", also als Träger einer zu erfassenden Messgröße, wobei Messobjekte definitionsgemäß Körper, Vorgänge oder Zustände sein können. In Kombination mit zumindest einem Messsensor, der zum Erfassen zumindest einer dem Außenleiter zuzurechnenden Messgröße geeignet ist, gelingt es, mit dem Messmodul die jeweils entsprechende Messgröße zu erfassen. Die jeweilige Messung kann dabei gegebenenfalls über den jeweiligen Phasenkontakt erfolgen. Je nach interessierender Messgröße kann es erforderlich sein, dass gegebenenfalls auch mehrere Messsensoren je Außenleiter bzw. je Phasenkontakt durch entsprechend geeignete Verschaltung zusammenwirken, um eine oder mehrere Messgrößen des jeweiligen Messobjekts in Form eines Außenleiters zu erfassen.

Streng genommen handelt es sich beispielsweise anhand einer gemessenen Stromstärke als erfasster Messgröße nicht um die gemessene Stromstärke je Phasenkontakt, sondern um die gemessene Stromstärke je Phase bzw. um die von einem entsprechenden Messsensor erfasste Stromstärke. Der zugehörige Phasenkontakt kann das jeweilige Kontaktstück je Phase mit der erforderlichen elektrischen Verbindung bzw. Versorgung des entsprechenden Messsensors bilden, wobei der jeweilige Messsensor nicht notwendigerweise in direktem elektrischen Kontakt mit der entsprechenden Phase stehen muss. Beispielsweise kann die Messung der Stromstärke auch berührungslos bzw. kontaktlos mittels des gebildeten Magnetfelds erfolgen.

Der zumindest eine Phasenkontakt kann im Rahmen der Erfindung auch als Kontaktklemme ausgeführt sein.

Bei einem erfindungsgemäßen Messmodul ist jedem Phasenkontakt und somit jedem einzelnen Außenleiter jeweils zumindest ein eigener Funktionsindikator zugeordnet, wobei der zumindest eine Funktionsindikator am Modulgehäuse angeordnet ist. Dies hat den Vorteil, dass für jeden Außenleiter bzw. für jeden einzelnen Phasenkontakt zum Anschließen an einen jeweiligen Außenleiter jeweils zumindest ein individueller Funktionsindikator am Gerätegehäuse des Messmoduls bereitsteht, wobei das Messmodul dazu eingerichtet ist, den jeweiligen Funktionsindikator in Abhängigkeit von der zumindest einen erfassten Messgröße anzusteuern. Somit kann die zumindest eine erfasste Messgröße, die einem bestimmten Außenleiter zuzurechnen ist, vom jeweils dem Phasenkontakt zugeordneten zumindest einen Funktionsindikator angezeigt werden. "Anschließen" ist im Rahmen der gegenständlichen Erfindung insbesondere als Herstellen einer elektrischen Verbindung bzw. Kontaktierung zu verstehen.

Beim erfindungsgemäßen Messmodul ist die Ansteuerung des jeweiligen zumindest einen Funktionsindikators derart parametrierbar, dass zumindest ein Grenzwert der zumindest einen zu erfassenden Messgröße, vorzugsweise einstellbar, vordefiniert ist und wahlweise ein Überschreiten oder ein Unterschreiten des Grenzwerts als Fehlersignal mittels des jeweiligen zumindest einen Funktionsindikators angezeigt wird. Das erfindungsgemäße Messmodul vereint daher für den Benutzer sowohl die Vorteile einer raschen, eindeutigen und somit fehlerfreien Erfassbarkeit, ob ein aktuell angezeigter Messwert einer erfassten Messgröße im Rahmen bestimmter Grenzwerte bzw. Schwellenwerte der erfassten Messgröße liegt, als auch die Vorteile einer flexiblen Parametrierbarkeit der zu erfassenden Messgrößen, da beim Messmodul Grenzwerte bzw. Schwellenwerte der zu erfassenden Messgrößen entsprechend der jeweiligen Messaufgabe parametrierbar sind.

Der Auswahl und Ausführung des zumindest einen Funktionsindikators sind generell keine Grenzen gesetzt. Es ist beispielsweise möglich, im Rahmen der Erfindung für jeden Phasenkontakt jeweils einen oder mehrere Funktionsindikatoren zur phasenweisen Anzeige von Messgrößen als optische und/oder akustische Funktionsindikatoren auszuführen.

Besonders zweckmäßig kann es sein, den zumindest einen Funktionsindikator je Phasenkontakt als optische Funktionsanzeige auszuführen. In einer besonders robusten und kostengünstigen Ausführungsvariante der Erfindung kann ein solcher optischer Funktionsindikator beispielsweise in Form einer oder mehrerer LED-Signalleuchten ausgeführt sein.

Zusätzlich zum jeweiligen Funktionsindikator kann auch zumindest ein Anzeigedisplay vorgesehen sein, auf dem beispielsweise während des Betriebs des Messmoduls jeweils aktuelle Messwerte einer oder mehrerer Messgrößen angezeigt werden.

In einer weiteren vorteilhaften Ausführungsform der Erfindung können bei einem Messmodul zumindest zwei Phasenkontakte vorgesehen sein, wobei die zumindest zwei Phasenkontakte einen ersten Phasenkontakt zum Anschließen eines ersten Außenleiters sowie einen zweiten Phasenkontakt zum Anschließen eines zweiten Außenleiters umfassen, und wobei dem ersten Phasenkontakt zumindest ein am Modulgehäuse angeordneter erster Funktionsindikator sowie dem zweiten Phasenkontakt zumindest ein am Modulgehäuse angeordneter zweiter Funktionsindikator zugeordnet sind.

Diese Ausführung bietet den Vorteil, dass in ein und demselben Messmodul zwei oder mehrere separate Phasenkontakte zum Anschließen jeweils an einen eigenen Außenleiter vorgesehen sind, wobei je Phasenkontakt zumindest ein eigener Messsensor zum Erfassen einer Messgröße vorgesehen ist.

Insbesondere zum Erfassen von Messgrößen eines Drehstromsystems mit drei Leitern kann der Einsatz eines erfindungsgemäßen Messmoduls besonders vorteilhaft sein, bei dem drei Phasenkontakte, bestehend aus einem ersten Phasenkontakt, einem zweiten Phasenkontakt und einem dritten Phasenkontakt, vorgesehen sind, wobei der erste Phasenkontakt zum Anschließen eines ersten Außenleiters, der zweite Phasenkontakt zum Anschließen eines zweiten Außenleiters und der dritte Phasenkontakt zum Anschließen eines dritten Außenleiters dienen, und wobei dem ersten Phasenkontakt zumindest ein am Modulgehäuse angeordneter erster Funktionsindikator, dem zweiten Phasenkontakt zumindest ein am Modulgehäuse angeordneter zweiter Funktionsindikator sowie dem dritten Phasenkontakt zumindest ein am Modulgehäuse angeordneter dritter Funktionsindikator zugeordnet sind.

Zweckmäßig kann es sein, wenn bei einem Messmodul gemäß der Erfindung der zumindest eine Funktionsindikator je Phasenkontakt eine LED-Signalleuchte, vorzugsweise eine zweifarbig oder mehrfarbig umschaltbare LED-Signalleuchte, umfasst.

Der Einsatz von LED-Signalleuchten bietet den Vorteil, dass LED-Leuchten generell robust sind, in der gewählten Ausführung nicht gekühlt werden müssen und somit praktisch wartungsfrei mit hoher Lebensdauer einsatzbereit sind, und außerdem aufgrund ihrer kompakten Bauweise nur einen geringen Platzbedarf aufweisen. Vorzugsweise kommen zweifarbig oder mehrfarbig umschaltbare LED-Signalleuchten zum Einsatz, wobei ein Farbwechsel der LED-Signalleuchten eindeutige Aufmerksamkeit schafft. Farbiges Licht bietet somit eine zusätzliche Signalfunktion, da rasch und eindeutig dem Benutzer angezeigt wird, sobald ein vordefinierter Grenzwert einer bestimmten Messgröße überschritten oder unterschritten wird. Damit können vom Benutzer beispielsweise Rückschlüsse auf den Zustand einer Maschine oder Anlage auf einen Blick getroffen werden. In einer weiteren vorteilhaften Ausführung der Erfindung können bei einem Messmodul zumindest zwei Funktionsindikatoren je Phasenkontakt vorgesehen sein, wobei die zumindest zwei Funktionsindikatoren vorzugsweise jeweils als LED-Signalleuchten, besonders bevorzugt als zweifarbig oder mehrfarbig umschaltbare LED-Signalleuchten, ausgeführt sind.

In dieser Ausführungsvariante kann beispielsweise ein erster Funktionsindikator je Phasenkontakt einen aktiven Betriebszustand anzeigen, während ein zweiter und/oder ein weiterer Funktionsindikator je Phasenkontakt so parametriert ist bzw. sind, dass dieser zweite oder weitere Funktionsindikator wahlweise ein Überschreiten oder ein Unterschreiten eines eingestellten Grenzwerts der zu erfassenden Messgröße als Fehlersignal anzeigt.

Vorteilhaft wird mit einem Messmodul gemäß der Erfindung, abhängig von der jeweiligen Ausstattung des Messmoduls, mit den jeweils erforderlichen Messsensoren zumindest eine Messgröße erfasst, welche Messgröße ausgewählt ist aus der Gruppe umfassend: elektrische Stromstärke, elektrische Spannung, elektrische Leistung, Ohmscher Widerstand, Energieverbrauch, Leistungsfaktor, Wirkfaktor, Temperatur eines elektrischen Kontakts.

Ein solches Messmodul kann besonders vielseitig eingesetzt werden, wobei das erfindungsgemäße Messmodul zur Erfassung von zwei oder mehreren Messgrößen ausgestattet ist, die vorzugsweise gleichzeitig, also simultan, erfasst werden können. So kann es beispielhaft zweckmäßig sein, wenn in einem Ausführungsbeispiel mit einem erfindungsgemäßen Messmodul für jeden Phasenkontakt gleichzeitig die jeweils anliegende elektrische Stromstärke sowie die aktuelle Temperatur, die an einer Kontaktklemme des jeweiligen Phasenkontakts herrscht, erfasst werden können.

Unter dem Leistungsfaktor λ (Lambda), der auch als Wirkleistungsfaktor bezeichnet wird, versteht man in der elektrischen Wechselstromtechnik das Verhältnis vom Betrag der Wirkleistung P zur Scheinleistung S. Der Leistungsfaktor λ kann zwischen 0 und 1 liegen.

Ausschließlich bei sinusförmigen Wechselgrößen kann der Wirkfaktor definiert werden aus dem Verhältnis der Wirkleistung zur Scheinleistung. Der Wirkfaktor ist gleich dem Kosinus des Phasenverschiebungswinkels φ (Phi).

Zweckmäßig kann sein, wenn bei einem erfindungsgemäßen Messmodul das Modulgehäuse zumindest ein Befestigungselement aufweist. In einer bevorzugten Ausführungsvariante kann das zumindest eine Befestigungselement eine Befestigungsöse sein oder eine solche Befestigungsöse umfassen, die zum Befestigen des Messmoduls an einer Halterung im weitesten Sinne geeignet ist. Beispielsweise kann die Befestigungsöse zum Befestigen an einem oder mehreren Außenleitern dienen, welche in diesem Fall als Halterung fungieren. Alternativ oder in Ergänzung dazu kann in einer weiteren bevorzugten Ausführungsvariante das zumindest eine Befestigungselement eine Gehäuseausnehmung sein oder eine solche umfassen, die zum Befestigen an einer Tragschiene, beispielsweise an einer Hutschiene, geeignet ist.

Diese Ausführungsvariante eines Messmoduls bietet den Vorteil, besonders einfach und flexibel am jeweiligen Einsatzort befestigt werden zu können. Dies kann beispielsweise ein Niederspannungsverteiler mit vorbereiteten Tragschienen, beispielsweise Hutschienen, sein, an denen das Messmodul mit einer entsprechenden Gehäuseausnehmung befestigt werden kann. Im Ausführungsfall, dass das zumindest eine Befestigungselement eine Befestigungsöse ist oder eine solche Befestigungsöse umfasst, kann das Messmodul besonders flexibel an den Kabeln und/oder Außenleitern des zu messenden Stromkreises oder an beliebigen vorhandenen Halterungen, Kabeltrassen und dergleichen befestigt werden, wobei gegebenenfalls geeignete zusätzliche Montagehilfsmittel wie beispielsweise Kabelbinder zur Befestigung erforderlich sein können.

Die eingangs genannten Aufgaben werden auch mit einer Messeinrichtung mit zumindest einem Messmodul, vorzugsweise mit mehreren Messmodulen, gemäß der Erfindung sowie mit einem Kommunikationsmodul gelöst, wobei das Kommunikationsmodul ein Gehäuse aufweist und signaltechnisch mittels eines, insbesondere drahtlosen, Kommunikationskanals mit dem zumindest einen Messmodul gekoppelt ist, wobei das zumindest eine Messmodul eine Schnittstelle zur Übergabe von vom zumindest einen Messsensor erfassten digitalen Messdaten an das Kommunikationsmodul aufweist, und wobei das Kommunikationsmodul einen Datenspeicher zum Speichern der digitalen Messdaten aufweist.

Die Schnittstelle des zumindest einen Messmoduls kann neben der Datenübertragung der erfassten Messdaten vom zumindest einen Messmodul an das Kommunikationsmodul weiters auch als Datenschnittstelle für ein externes mobiles Endgerät dienen. Für den Ausführungsfall, dass das Messmodul mit einer Funk-Schnittstelle, beispielsweise einer Bluetooth- oder ZigBee-tauglichen Funk-Schnittstelle ausgerüstet ist, kann eine Kommunikation bzw. Datenübertragung zwischen dem Messmodul und einem externen mobilen Endgerät mittels Funksignalen beispielsweise via Bluetooth erfolgen, sofern das verwendete Endgerät mit einer entsprechend geeigneten Software ausgestattet ist.

Für den Ausführungsfall, dass die Kommunikation bzw. Datenübertragung zwischen dem Messmodul und einem externen mobilen Endgerät web- und/oder internet-basiert erfolgen soll, ist das Kommunikationsmodul zweckmäßigerweise als Gateway ausgerüstet. In diesem Falle ist auch ein Webserver implementiert. Ein Benutzer kann dann beispielsweise internet-basiert via eines Webbrowser-Zugangs von einem mobilen Endgerät aus Details zu den erfassten digitalen Messdaten auslesen und Geräteparameter des Messmoduls überprüfen und diese gegebenenfalls verändern bzw. parametrieren.

Ebenso kann das Kommunikationsmodul eine oder mehrere Datenschnittstellen beispielsweise für ein externes mobiles Endgerät und/oder für stationäre Endgeräte, Standrechner, Netzwerkrechner und dergleichen aufweisen, mit dem ein Benutzer beispielsweise internet-basiert via eines Webbrowser-Zugangs von einem mobilen Endgerät oder einem Netzwerkrechner aus die im Datenspeicher des Kommunikationsmoduls gespeicherten digitalen Messdaten auslesen kann und/oder über den Kommunikationskanal Details zu den erfassten digitalen Messdaten auslesen kann und Geräteparameter des Messmoduls überprüfen und gegebenenfalls verändern bzw. parametrieren kann.

In einer Weiterbildung der Erfindung kann das Kommunikationsmodul beispielsweise auch ein Anzeigendisplay zur Visualisierung der Messdaten aufweisen.

Besonders zweckmäßig kann es sein, wenn bei einer Messeinrichtung gemäß der Erfindung das Kommunikationsmodul ein mobiles Endgerät, vorzugsweise ein Smartphone und/oder einen Notebook-Rechner, umfasst oder ein mobiles Endgerät ist.

Je nach Anwendungsfall kann es vorteilhaft sein, wenn bei einer erfindungsgemäßen Messeinrichtung entweder das zumindest eine Messmodul im Gehäuse des Kommunikationsmoduls integriert ist, oder das zumindest eine Messmodul und das Kommunikationsmodul dazu eingerichtet sind, um zumindest ein Modulgehäuse mit dem Gehäuse des Kommunikationsmoduls lösbar koppeln zu können.

Die vorgenannte Ausführungsvariante, wonach das zumindest eine Messmodul im Gehäuse des Kommunikationsmoduls integriert ist, bietet den Vorteil einer besonders kompakten Anordnung der einzelnen Messmodule in einem gemeinsamen Gehäuse des Kommunikationsmoduls. Im Ausführungsfall, bei dem bei einem Messsystem zumindest ein Modulgehäuse eines Messmoduls mit dem Gehäuse des Kommunikationsmoduls lösbar gekoppelt werden kann, können Messmodule erforderlichenfalls besonders einfach und flexibel getauscht werden.

Die Messmodule und das Kommunikationsmodul kommunizieren üblicherweise signaltechnisch in einem Nahbereich miteinander, da die einzelnen Module beispielsweise im selben Schaltschrank eines Niederspannungsverteilers montiert sind. Im Falle einer Geräteintegration des zumindest einen Messmoduls im Gehäuse des Kommunikationsmoduls und/oder im Falle von lösbar gekoppelten bzw. zusammensteckbaren Gehäusen der einzelnen Module kann anstelle eines drahtlosen Kommunikationskanals für den Datentransfer zwischen den einzelnen Modulen auch ein drahtgebundener Kommunikationskanal für den Datentransfer realisiert sein. Beispielsweise können entsprechende komplementäre bzw. zueinander korrespondierende Stecker-/ Steckbuchsen-Verbindungen in den koppelbaren bzw. zusammensteckbaren Gehäusen für die Herstellung eines drahtgebundenen Kommunikationskanals dienen.

In einer Weiterbildung der Erfindung kann auch ein Messsystem mit zumindest einem Messmodul, vorzugsweise mit mehreren Messmodulen, oder mit einer Messeinrichtung angegeben werden, wobei das Messsystem weiterhin einen Lasttrennschalter umfasst, wobei der Lasttrennschalter ein Schaltergehäuse, zumindest eine Phasenklemme zum Anschließen an jeweils einen Außenleiter sowie zumindest eine Schalterklemme zum Anschließen an jeweils eine weiterführende Leitung aufweist und dazu eingerichtet ist, eine elektrische Verbindung zwischen der zumindest einen Phasenklemme und der zumindest einen Schalterklemme wahlweise ein- oder auszuschalten, und wobei der zumindest eine Phasenkontakt des zumindest einen Messmoduls komplementär zur zumindest einen Phasenklemme und/oder zur zumindest einen Schalterklemme des Lasttrennschalters geformt ist, um in der zumindest einen Phasenklemme oder Schalterklemme mitgeklemmt werden zu können.

Der Einsatz eines solchen Messsystems gemäß der Erfindung bietet den Vorteil, dass ein oder mehrere Messmodule mit ihren Phasenkontakten an Phasenklemmen oder Schalterklemmen des Lastrennschalters mitgeklemmt werden können, wodurch eine besondere kompakte Anordnung des Lasttrennschalters mit dem einen oder den mehreren daran mitgeklemmten Messmodulen erzielt werden kann. Weiters werden mögliche Kontaktfehler zwischen dem Lastrennschalter und dem zumindest einen mitgeklemmten Messmodul vermieden.

Je nach Anwendungsfall kann es vorteilhaft sein, wenn bei einem erfindungsgemäßen Messsystem entweder das zumindest eine Messmodul im Schaltergehäuse des Lasttrennschalters integriert ist, oder zumindest ein Messmodul und der Lasttrennschalter dazu eingerichtet sind, um zumindest ein Modulgehäuse mit dem Schaltergehäuse des Lasttrennschalters lösbar koppeln zu können.

Es wird dazu auf die vorgenannten Vorteile von Modulen, die in einem Gehäuse integriert sind, oder die in miteinander lösbar koppelbaren Gehäusen angeordnet sind, verwiesen. Die vorgenannten Vorteile gelten sinngemäß gleichermaßen für die hier genannten Ausführungsvarianten, wonach zumindest ein Messmodul im Schaltergehäuse des Lasttrennschalters integriert oder mit dem Schaltergehäuse des Lasttrennschalters lösbar koppelbar ist.

In einer Weiterbildung der Erfindung kann überdies ein Niederspannungsverteiler mit zumindest einem Messmodul, vorzugsweise mit mehreren Messmodulen, oder mit einer Messeinrichtung, oder aber mit einem Messsystem angegeben werden.

### KURZE BESCHREIBUNG DER FIGUREN

Die Erfindung wird nun anhand von Ausführungsbeispielen näher erläutert. Die schematischen Zeichnungen sind beispielhaft und sollen den Erfindungsgedanken zwar darlegen, ihn aber keinesfalls einengen oder gar abschließend wiedergeben.

Dabei zeigen:
- **Fig. 1**: eine erste Ausführungsvariante eines erfindungsgemäßen Messmoduls in einer isometrischen Seitenansicht schräg von oben vorne;
- **Fig. 2**: das in Fig. 1 veranschaulichte Messmodul in einer Frontalansicht der Oberseite;
- **Fig. 3**: das in Fig. 1 veranschaulichte Messmodul in einer Frontalansicht der vorderen Seitenfläche;
- **Fig. 4**: ein erfindungsgemäßes Messsystem umfassend ein Messmodul sowie einen Lasttrennschalter vor dem Koppeln der beiden Bauteile;
- **Fig. 5**: eine zweite Ausführungsvariante eines erfindungsgemäßen Messmoduls in geöffneter Anordnung ohne Abdeckungsdeckel in einer isometrischen Ansicht schräg von unten;
- **Fig. 6**: das in Fig. 5 veranschaulichte Messmodul in einer Frontalansicht von unten;
- **Fig. 7**: in einer schematischen Darstellung eine Anordnung einer Messeinrichtung gemäß der Erfindung mit einem Messmodul sowie mit einem Kommunikationsmodul, die beide an einer Tragschiene beispielsweise in einem Schaltschrank eines Niederspannungsverteilers befestigt sind;
- **Fig. 8**: eine Anordnung vergleichbar mit jener in Fig. 7 gezeigten Anordnung, wobei ein mobiles Endgerät als Kommunikationsmodul dient;
- **Fig. 9**: in einer schematischen Darstellung eine Anordnung eines Messsystems gemäß der Erfindung mit einem Messmodul, einem Kommunikationsmodul, sowie mit einem Lasttrennschalter;
- **Fig. 10**: eine Anordnung vergleichbar mit jener in Fig. 9 gezeigten Anordnung, wobei ein mobiles Endgerät als Kommunikationsmodul dient.

### WEGE ZUR AUSFÜHRUNG DER ERFINDUNG

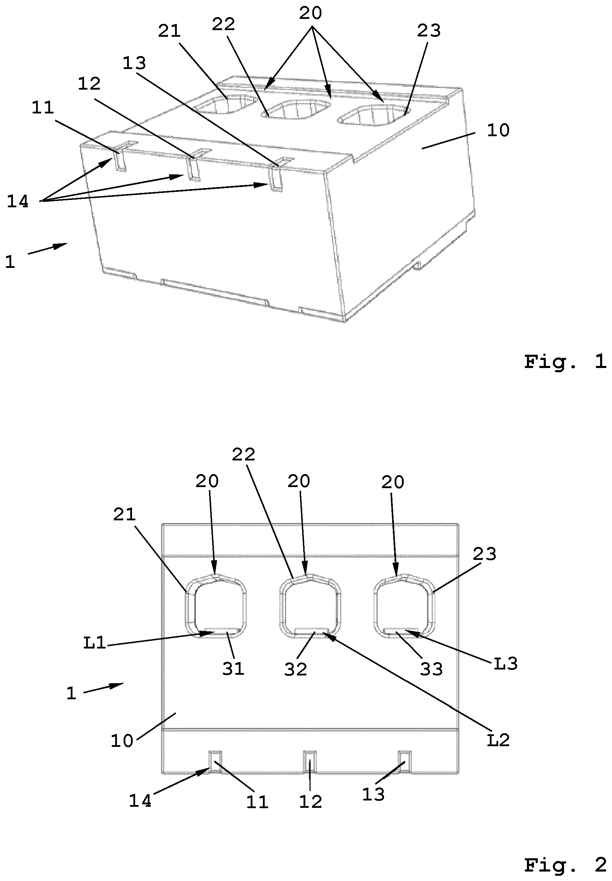

Die Figuren 1 bis 3 zeigen in unterschiedlichen Ansichten eine erste Ausführung eines erfindungsgemäßen Messmoduls 1. Beginnend mit **Fig. 1** umfasst das gezeigte Messmodul 1 ein Modulgehäuse 10, wobei hier für jeden Phasenkontakt jeweils ein eigener Funktionsindikator 11,12,13 vorgesehen ist. Die Funktionsindikatoren 11,12,13 sind jeweils am Modulgehäuse 10 angeordnet. Im Modulgehäuse 10 sind hier mehrere Messsensoren 20 vorgesehen, wobei ein erster Messsensor 21, ein zweiter Messsensor 22 sowie ein dritter Messsensor 23 beispielsweise jeweils als Strommesssensoren ausgeführt sind. Strommesssensoren bzw. Stromwandler sind elektrische Bauelemente, mit denen die Stromstärke in Kabeln und Stromschienen galvanisch getrennt - und damit berührungslos - anhand der durch elektrische Ströme ausgelösten magnetischen Flussdichte gemessen werden kann.

In **Fig. 2****,** welche die Oberseite des Messmoduls 1 zeigt, ist durch Kabeldurchführungen zur Strommessung hindurch zu erkennen, dass an der in Fig. 2 im Bildhintergrund befindlichen Unterseite des Messmoduls 1 drei Phasenkontakte 31,32,33 angeordnet sind. Die entsprechenden Strommesssensoren sind unsichtbar im Geräteinneren des Messmoduls 1 angeordnet. Die Phasenkontakte 31,32,33 dienen jeweils phasenweise zum Anschließen bzw. elektrischen Kontaktieren eines ersten Außenleiters L1 bzw. einer ersten Phase L1, eines zweiten Außenleiters L2 bzw. einer zweiten Phase L2 sowie eines dritten Außenleiters L3 bzw. einer dritten Phase L3.

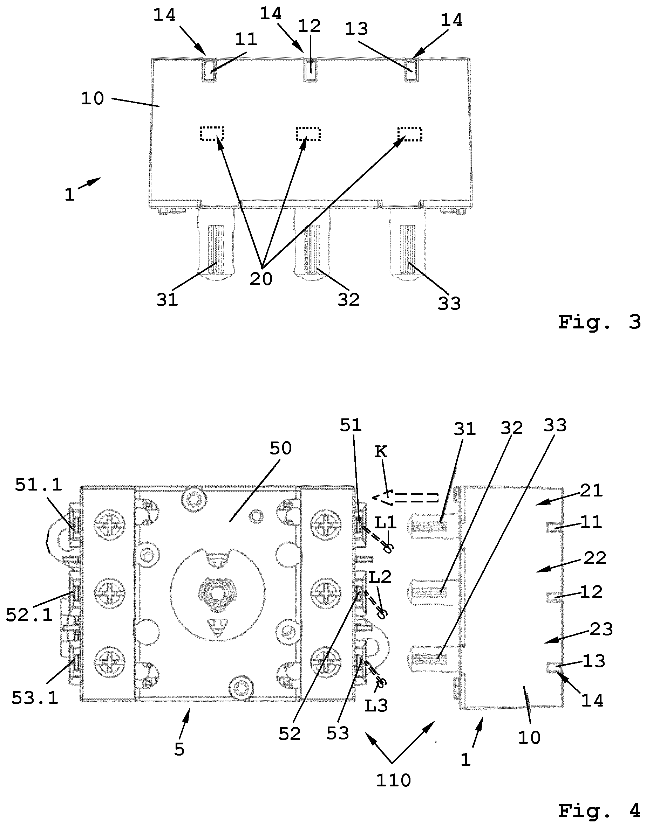

**Fig. 3** zeigt in der Vorderansicht des Messmoduls 1 die drei separaten Phasenkontakte 31,32,33.

Das hier gezeigte erfindungsgemäße Messmodul 1 dient zum Messen zumindest einer Messgröße in einem Niederspannungsnetz, wobei das Messmodul 1 drei separate Phasenkontakte 31,32,33 zum Anschließen an jeweils einen Außenleiter L1,L2,L3 sowie zumindest drei Messsensoren 20,21,22,23 zum Erfassen zumindest einer dem jeweiligen Außenleiter L1,L2,L3 zuzurechnenden Messgröße umfasst, wobei die hier sichtbaren Messsensoren 21,22,23 jeweils als Strommesssensoren ausgeführt sind. Weitere Messsensoren 20 (angedeutet durch punktierte Rechtecke) können von außen unsichtbar im Gehäuseinneren des Messmoduls 1 angeordnet sein. Im Detail sind hier drei Phasenkontakte 31,32,33 vorgesehen, bestehend aus einem ersten Phasenkontakt 31, einem zweiten Phasenkontakt 32 und einem dritten Phasenkontakt 33, wobei der erste Phasenkontakt 31 zum Anschließen eines ersten Außenleiters L1, der zweite Phasenkontakt 32 zum Anschließen eines zweiten Außenleiters L2 und der dritte Phasenkontakt 33 zum Anschließen eines dritten Außenleiters L3 dienen.

Für jeden Phasenkontakt 31,32,33 ist jeweils zumindest ein Funktionsindikator 11,12,13 vorgesehen, wobei der jeweilige zumindest eine Funktionsindikator 11,12,13 am Modulgehäuse 10 angeordnet ist, und wobei das Messmodul 1 dazu eingerichtet ist, den jeweiligen zumindest einen Funktionsindikator 11,12,13 in Abhängigkeit von der zumindest einen erfassten Messgröße anzusteuern. Das hier gezeigte Messmodul 1 ist dazu eingerichtet, dass die Ansteuerung des jeweiligen zumindest einen Funktionsindikators 11,12,13 derart parametrierbar ist, dass zumindest ein Grenzwert der zumindest einen zu erfassenden Messgröße einstellbar vordefiniert ist und wahlweise ein Überschreiten oder ein Unterschreiten des Grenzwerts als Fehlersignal 14 mittels des jeweiligen zumindest einen Funktionsindikators 11,12,13 angezeigt wird.

Die Funktionsindikatoren 11,12,13 sind hier jeweils als mehrfarbig umschaltbare LED-Signalleuchten ausgeführt, wobei das Überschreiten und/oder Unterschreiten eines vordefinierten bzw. eingestellten Grenzwerts als Fehlersignal 14 angezeigt wird, wobei sich die Farbe der Funktionsindikatoren 11,12,13 bei Anzeige eines Fehlersignals 14 jeweils von der Farbe der Funktionsindikatoren 11,12,13 im Normalbetrieb unterscheidet.

Beispielhaft kann es zweckmäßig sein, wenn im Falle einer Messung der elektrischen Stromstärke je Phase bzw. Messsensor, wobei der entsprechende Phasenkontakt 31,32,33 das jeweilige Kontaktstück je Phase mit der elektrischen Verbindung bzw. Versorgung darstellt, vom Messmodul 1 der jeweilige Funktionsindikator 11,12,13 bzw. die jeweilige LED-Signalleuchte 11,12,13 so angesteuert wird, dass im Normalbetrieb, wenn also beispielsweise ein vordefinierter bzw. voreingestellter Grenzwert einer maximalen Stromstärke unterschritten wird, die jeweilige LED-Signalleuchte 11,12,13 in grüner Farbe leuchtet. Im Falle des Überschreitens der voreingestellten maximalen Stromstärke wird beispielsweise die jeweilige LED-Signalleuchte 11,12,13 so angesteuert, dass ein Farbumschlag erfolgt und die betreffende LED-Signalleuchte 11,12,13 daraufhin jeweils ein rot leuchtendes oder rot blinkendes Fehlersignal 14 anzeigt.

Alternativ zur in Fig. 3 gezeigten Ausführung können die Phasenkontakte 31,32,33 im Rahmen der Erfindung beispielsweise auch als Kontaktklemmen ausgeführt sein.

**Fig. 4** zeigt ein erfindungsgemäßes Messsystem 110 umfassend ein Messmodul 1 gemäß der zuvor in den Figuren 1 bis 3 gezeigten Ausführung mit drei Phasenkontakten 31,32,33, sowie einen Lasttrennschalter 5 vor dem Koppeln K der beiden Bauteile.

Der hier gezeigte Lasttrennschalter 5 weist ein Schaltergehäuse 50, drei Phasenklemmen 51,52,53 zum Anschließen an jeweils einen Außenleiter L1,L2,L3 sowie drei Schalterklemmen 51.1,52.1,53.1 zum Anschließen an jeweils eine weiterführende Leitung auf und ist dazu eingerichtet, eine elektrische Verbindung zwischen einer Phasenklemme 51,52,53 und jeweils einer Schalterklemme 51.1,52.1,53.1, die mit der jeweiligen Phasenklemme 51,52,53 korrespondiert, wahlweise ein- oder auszuschalten, wobei die drei Phasenkontakte 31,32,33 des Messmoduls 1 hier jeweils komplementär zu den Phasenklemmen 51,52,53 des Lasttrennschalters 5 geformt sind, um in den Phasenklemmen 51,52,53 mitgeklemmt werden zu können.

Eine solche Anordnung, die in Fig. 4 gezeigt ist und bei der das Messmodul 1 mit seinen Phasenkontakten 31,32,33 eingangsseitig an den Phasenklemmen 51,52,53 des Lasttrennschalters 5 mitgeklemmt wird, bietet den Vorteil, dass das Messmodul 1 auch dann mit den Außenleitern L1,L2,L3 in Verbindung steht und von diesen mit Strom versorgt wird, wenn der Lasttrennschalter 5 ausgeschaltet ist.

Im Rahmen der Erfindung ist jedoch auch eine in Bezug zu Fig. 4 umgekehrte Anordnung denkbar, bei der die Phasenkontakte 31,32,33 des Messmoduls 1 so geformt sind, dass sie an der Seite der Schalterklemmen 51.1,52.1,53.1 des Lasttrennschalters 5 mitgeklemmt werden können. Diese in Bezug zu Fig. 4 umgekehrte Anordnung von Messmodul 1 und Lasttrennschalter 5 ist in den Figuren nicht explizit dargestellt.

Mit einem strichlierten Pfeil K ist in Fig. 4 eine Koppelrichtung K angedeutet, in der die beiden Bauteile, nämlich das Messmodul 1 und der Lasttrennschalter 5, miteinander gekoppelt werden können, wobei die Phasenkontakte 31,32,33 des Messmoduls 1 an die Phasenklemmen 51,52,53 des Lasttrennschalters 5 angeschlossen bzw. in diese eingeschoben werden.

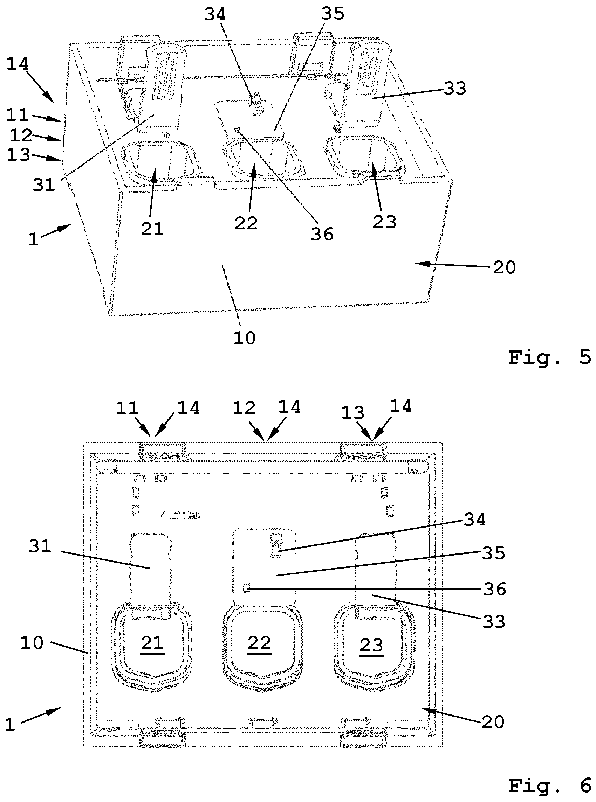

Die beiden Abbildungen **Fig. 5** und **Fig. 6** betreffen eine zweite Ausführungsvariante eines erfindungsgemäßen Messmoduls 1, bei dem für die baugleich ausgeführten Phasenkontakte 31,32,33 jeweils ein Temperatursensor 36 zur Erfassung der Temperatur jeweils eines elektrischen Kontakts, nämlich des jeweiligen Phasenkontakts 31,32,33, vorgesehen ist. Eine elektrische Verbindung zwischen einer nicht näher bezeichneten Leiterplatte und den Phasenkontakten 31,32,33 erfolgt hier beispielsweise jeweils mittels SMD-Federkontakten 34 (Surface-Mounted Device bzw. oberflächenmontiertes Bauelement). Die Phasenkontakte 31,32,33 sind jeweils auf wärmeleitenden Anschlussplatten 35 befestigt, in welchen die Temperatursensoren 36 zumindest abschnittsweise eingegossen sind. Zur einfacheren Darstellung sind in Fig. 5 und in Fig. 6 jeweils das Messmodul 1 in geöffneter Anordnung ohne Abdeckungsdeckel gezeigt und jeweils der mittlere Phasenkontakt 32 entfernt dargestellt, um die darunterliegenden Bauteile 34, 35 und 36 zu erkennen. Im Betriebszustand des Messmoduls 1 ist das Modulgehäuse 10 mit einem Abdeckungsdeckel geschlossen und es ist auch der mittlere Phasenkontakt 32 vergleichbar mit den beiden äußeren Phasenkontakten 31,33 befestigt.

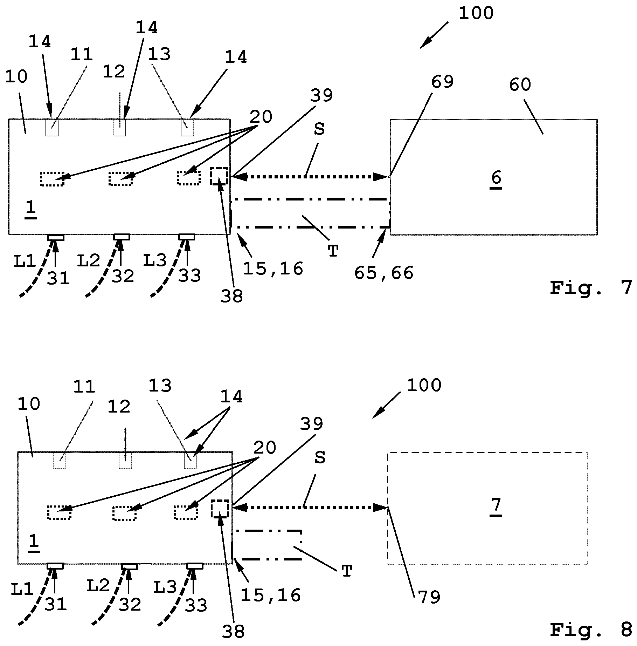

**Fig. 7** zeigt schematisch eine Anordnung einer Messeinrichtung 100 gemäß der Erfindung mit einem Messmodul 1 sowie mit einem Kommunikationsmodul 6, die beide beispielsweise an einer Hut- bzw. Tragschiene T beispielsweise in einem Schaltschrank eines Niederspannungsverteilers befestigt sind. Die Lage der Tragschiene T ist mit strichzweipunktierten Linien angedeutet. Das Messmodul 1 umfasst drei Phasenkontakte 31,32,33, bestehend aus einem ersten Phasenkontakt 31, einem zweiten Phasenkontakt 32 und einem dritten Phasenkontakt 33, wobei der erste Phasenkontakt 31 zum Anschließen eines ersten Außenleiters L1, der zweite Phasenkontakt 32 zum Anschließen eines zweiten Außenleiters L2 und der dritte Phasenkontakt 33 zum Anschließen eines dritten Außenleiters L3 dienen. Die Außenleiter L1,L2,L3 sind jeweils strichliert angedeutet. Dem ersten Phasenkontakt 31 ist ein erster Funktionsindikator 11, dem zweiten Phasenkontakt 32 ist ein zweiter Funktionsindikator 12 sowie dem dritten Phasenkontakt 33 ist ein dritter Funktionsindikator 13 zugeordnet. Die Funktionsindikatoren 11,12,13 sind jeweils am Modulgehäuse 10 angeordnet.

Im Messmodul 1 sind hier mehrere Messsensoren 20 zum Erfassen zumindest einer dem jeweiligen Außenleiter L1,L2,L3 zuzurechnenden Messgröße umfasst. Beispielsweise sind hier entsprechende Messsensoren 20 vorgesehen, die für jeden Außenleiter L1,L2,L3 jeweils die elektrische Stromstärke, die elektrische Spannung, die elektrische Leistung, die Temperatur des elektrischen Kontakts sowie den Ohmschen Widerstand messen können. Das Messmodul 1 ist dazu eingerichtet, den jeweiligen Funktionsindikator 11,12,13 in Abhängigkeit von der jeweils erfassten Messgröße anzusteuern.

Das Messmodul 1 ist dazu eingerichtet, dass die Ansteuerung des jeweiligen Funktionsindikators 11,12,13 derart parametrierbar ist, dass zumindest ein Grenzwert der zumindest einen zu erfassenden Messgröße von einem Benutzer einstellbar vordefiniert werden kann und wahlweise ein Überschreiten oder ein Unterschreiten des Grenzwerts als Fehlersignal 14 mittels des jeweiligen zumindest einen Funktionsindikators 11,12,13 angezeigt wird. Die Funktionsindikatoren 11,12,13 sind hier beispielsweise jeweils zweifarbig umschaltbare LED-Signalleuchten, wobei eine Anzeigefarbe zur Anzeige des jeweiligen Fehlersignals 14 je Phasenkontakt 31,32,33 sich jeweils von einer Anzeigefarbe zur Anzeige des normalen Messbetriebs der einzelnen Funktionsindikatoren 11,12,13 unterscheidet.

Das Modulgehäuse 10 des Messmoduls 1 weist ein Befestigungselement 15 auf, welches hier beispielsweise als eine Gehäuseausnehmung 16 zum Befestigen des Modulgehäuses 10 an der Tragschiene T ausgeführt ist. Weiters weist das Messmodul 1 eine Schnittstelle 38 (angedeutet durch ein strichliertes Quadrat) samt einem entsprechenden Signal-Ein-/Ausgang 39 zur Übergabe der von den Messsensoren 20 (angedeutet durch punktierte Rechtecke) erfassten, digitalen Messdaten an ein externes Gerät auf.

Das Kommunikationsmodul 6 dient hier als externes Gerät zur Übernahme und Speicherung der vom Messmodul 1 übergebenen, digitalen Messdaten. Das Kommunikationsmodul 6 umfasst ein Gehäuse 60 mit einem Befestigungselement 65, welches hier beispielsweise als eine Gehäuseausnehmung 66 zum Befestigen des Gehäuses 60 an der Tragschiene T ausgeführt ist.

Weiters umfasst das Kommunikationsmodul 6 einen Signal-Ein-/Ausgang 69 und kann signaltechnisch mittels eines Kommunikationskanals S zur Datenübertragung der erfassten digitalen Messdaten mit dem Messmodul 1 gekoppelt werden. Der Kommunikationskanal S ist in Fig. 7 mit einem strichlierten Doppelpfeil S symbolisiert und ist hier als drahtloser Kommunikationskanal S zwischen dem Signal-Ein-/Ausgang 39 des Messmoduls 1 und dem Signal-Ein-/Ausgang 69 des Kommunikationsmoduls 6 ausgeführt. Das Kommunikationsmodul 6 weist einen Datenspeicher zum Speichern der digitalen Messdaten auf.

**Fig. 8** zeigt eine Anordnung einer Messeinrichtung 100 vergleichbar mit jener in Fig. 7 gezeigten Anordnung, wobei hier ein mobiles Endgerät 7, beispielsweise ein Notebook-Rechner, als Kommunikationsmodul dient. Diese Ausführungsvariante bietet den Vorteil, dass mit dem mobilen Endgerät 7 neben der Datenspeicherung auch eine Auswertung der digitalen Messdaten besonders benutzerfreundlich möglich ist. Der Kommunikationskanal S ist in Fig. 8 mit einem strichlierten Doppelpfeil S symbolisiert und ist hier als drahtloser Kommunikationskanal S zwischen dem Signal-Ein-/Ausgang 39 des Messmoduls 1 und einem Signal-Ein-/Ausgang 79 des mobilen Endgeräts 7 ausgeführt. Im Übrigen wird hinsichtlich der Beschreibung des in Fig. 8 gezeigten Messmoduls 1 auf die sinngemäße Figurenbeschreibung von Fig. 7 verwiesen.

Im Ausführungsfall, dass das Modulgehäuse 10 des Messmoduls 1 zumindest ein Befestigungselement 15 aufweist, das eine Befestigungsöse ist oder eine solche Befestigungsöse umfasst, kann das Messmodul 1 besonders flexibel an Ort und Stelle an den Kabeln und/oder Leitungen des zu messenden Stromkreises oder an beliebigen vorhandenen Halterungen, Kabeltrassen und dergleichen befestigt werden, wobei gegebenenfalls geeignete zusätzliche Montagehilfsmittel wie beispielsweise Kabelbinder zur entsprechenden Befestigung an der einen oder den mehreren Befestigungsösen des Modulgehäuses 10 erforderlich sein können. Analog zum Vorgesagten kann in einer alternativen Ausführungsform auch das Kommunikationsmodul 6 ein Gehäuse 60 mit zumindest einem Befestigungselement 65 aufweisen, welches Befestigungselement 65 eine Befestigungsöse ist oder eine solche Befestigungsöse umfasst.

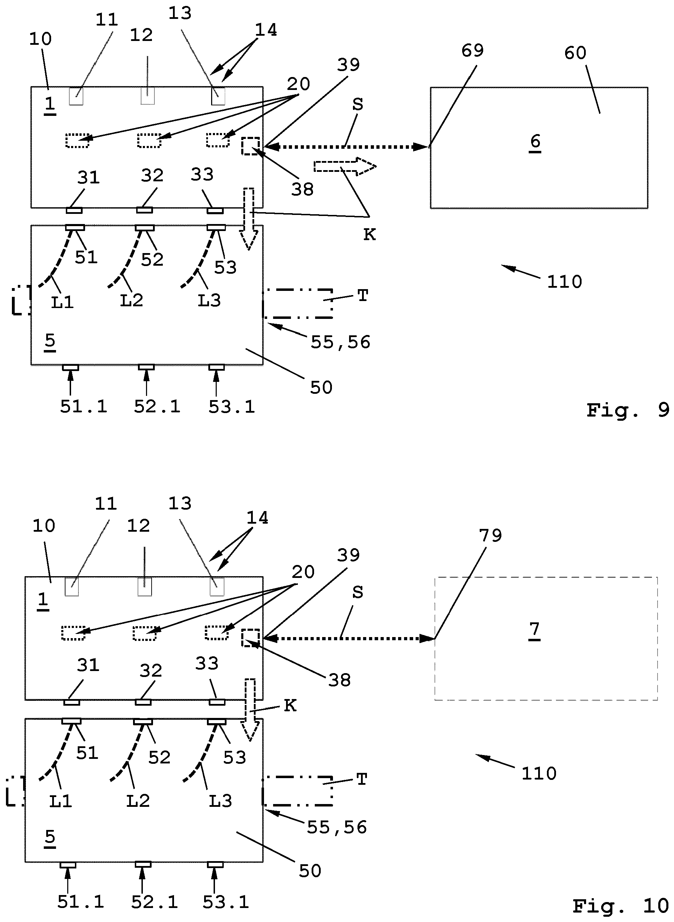

**Fig. 9** zeigt schematisch eine Anordnung eines Messsystems 110 gemäß der Erfindung mit einem Messmodul 1, einem Kommunikationsmodul 6, sowie mit einem Lasttrennschalter 5. Hinsichtlich der Beschreibung des in Fig. 9 gezeigten Messmoduls 1 sowie des Kommunikationsmoduls 6 wird auf die sinngemäße Figurenbeschreibung von Fig. 7 verwiesen. Abweichend von der Figurenbeschreibung von Fig. 7 können bei der in Fig. 9 gezeigten Ausführung jedoch das Modulgehäuse 10 des Messmoduls 1 und das Gehäuse 60 des Kommunikationsmoduls 6 lösbar miteinander gekoppelt werden, wobei eine Koppelrichtung K durch einen strichliert gezeichneten, waagrechten Pfeil K symbolisiert ist. Der Kommunikationskanal S kann im Fall einer Koppelung K des Modulgehäuses 10 mit dem Gehäuse 60 des Kommunikationsmoduls 6 auch als drahtbasierter Kommunikationskanal S ausgeführt sein, wobei der Signal-Ein-/Ausgang 39 des Messmoduls 1 und der Signal-Ein-/Ausgang 69 des Kommunikationsmoduls 6 jeweils als zueinander korrespondierende Stecker-/ Steckbuchsen-Verbindungen ausgeführt sind oder jeweils solche korrespondierende Stecker-/ Steckbuchsen-Verbindungen umfassen.

Der hier gezeigte Lasttrennschalter 5 weist ein Schaltergehäuse 50, drei Phasenklemmen 51,52,53 zum Anschließen an jeweils einen Außenleiter L1,L2,L3 sowie drei Schalterklemmen 51.1,52.1,53.1 zum Anschließen an jeweils eine weiterführende Leitung auf und ist dazu eingerichtet, eine elektrische Verbindung zwischen einer Phasenklemme 51,52,53 und jeweils einer Schalterklemme 51.1,52.1,53.1, die mit der jeweiligen Phasenklemme 51,52,53 korrespondiert, wahlweise ein- oder auszuschalten, wobei die drei Phasenkontakte 31,32,33 des Messmoduls 1 hier jeweils komplementär zu den Phasenklemmen 51,52,53 des Lasttrennschalters 5 geformt sind, um in den Phasenklemmen 51,52,53 mitgeklemmt werden zu können.

Mit einem strichlierten senkrechten Pfeil K ist in Fig. 9 eine Koppelrichtung K angedeutet, in der die beiden Bauteile, nämlich das Messmodul 1 und der Lasttrennschalter 5, miteinander gekoppelt werden können, wobei die Phasenkontakte 31,32,33 des Messmoduls 1 an die Phasenklemmen 51,52,53 des Lasttrennschalters 5 angeschlossen bzw. in diese eingeschoben werden. Das Gehäuse 50 des Lasttrennschalters 5 weist ein Befestigungselement 55 auf, welches hier beispielsweise als eine Gehäuseausnehmung 56 zum Befestigen des Schaltergehäuses 50 an der Tragschiene T ausgeführt ist.

Alternativ oder in Ergänzung kann das Gehäuse 50 des Lasttrennschalters 5 auch zumindest ein Befestigungselement 55 aufweisen, das eine Befestigungsöse ist oder eine solche Befestigungsöse umfasst. Die vorgenannten Vorteile hinsichtlich einer besonders flexiblen Montage der Gehäuse mittels entsprechender Befestigungsösen an Ort und Stelle der Messung gelten gleichermaßen für die Ausführungsform, bei der das Gehäuse 50 des Lasttrennschalters 5 mit geeigneten Befestigungsösen zur Halterung ausgerüstet ist.

**Fig. 10** zeigt eine Anordnung eines Messsystems 110 vergleichbar mit jener in Fig. 9 gezeigten Anordnung, wobei im Unterschied zu Fig. 10 hier ein mobiles Endgerät 7, beispielsweis ein Smartphone, als Kommunikationsmodul dient. Die Datenübertragung zwischen dem Messmodul 1 und dem mobilen Endgerät 7 erfolgt hier beispielsweise mittels eines drahtlosen Kommunikationskanals S funk-basiert.

Bei den in den Abbildungen Fig. 9 und Fig. 10 gezeigten Anordnungen wird das Messmodul 1 mit seinen Phasenkontakten 31,32,33 jeweils eingangsseitig an den Phasenklemmen 51,52,53 des Lasttrennschalters 5 mitgeklemmt. Eine solche Anordnung bietet jeweils den Vorteil, dass das Messmodul 1 auch dann mit den Außenleitern L1,L2,L3 in Verbindung steht und von diesen mit Strom versorgt wird, wenn der Lasttrennschalter 5 ausgeschaltet ist.

Ebenso ist es im Rahmen der Erfindung vorgesehen, dass anstelle der in Fig. 9 und/oder in Fig. 10 gezeigten Anordnung das Messmodul 1 mit seinen Phasenkontakten 31,32,33 ausgangsseitig an den Schalterklemmen 51.1,52.1,53.1 des Lasttrennschalters 5 mitgeklemmt werden kann. Bei einer solchen Anordnung, die in den Figuren nicht explizit gezeigt ist, ist allerdings zu beachten, dass das Messmodul 1 mit den Außenleitern L1,L2,L3 nicht in Verbindung steht und von diesen daher nicht mit Strom versorgt wird, wenn der Lasttrennschalter 5 ausgeschaltet ist.

### BEZUGSZEICHENLISTE

- 1: Messmodul
- 5: Lasttrennschalter
- 6: Kommunikationsmodul
- 7: mobiles Endgerät
- 10: Gehäuse des Messmoduls, Modulgehäuse
- 11: erster Funktionsindikator; erste LED
- 12: zweiter Funktionsindikator; zweite LED
- 13: dritter Funktionsindikator; dritte LED
- 14: Fehlersignal
- 15: Befestigungselement
- 16: Gehäuseausnehmung für Tragschiene
- 20: Messsensor
- 21: erster Messsensor; erster Strommesssensor
- 22: zweiter Messsensor; zweiter Strommesssensor
- 23: dritter Messsensor; dritter Strommesssensor
- 31: erster Phasenkontakt
- 32: zweiter Phasenkontakt
- 33: dritter Phasenkontakt
- 34: SMD-Federkontakt
- 35: Anschlussplatte
- 36: Temperatursensor
- 38: Schnittstelle zur Übergabe digitaler Messdaten
- 39: Signal-Ein-/Ausgang des Messmoduls
- 50: Gehäuse des Lasttrennschalters; Schaltergehäuse
- 51: erste Phasenklemme
- 52: zweite Phasenklemme
- 53: dritte Phasenklemme
- 51.1: erste Schalterklemme
- 52.2: zweite Schalterklemme
- 53.3: dritte Schalterklemme
- 55: Befestigungselement
- 56: Gehäuseausnehmung für Tragschiene
- 60: Gehäuse des Kommunikationsmoduls
- 65: Befestigungselement
- 66: Gehäuseausnehmung für Tragschiene
- 69: Signal-Ein-/Ausgang des Kommunikationsmoduls
- 79: Signal-Ein-/Ausgang des mobilen Endgeräts
- 100: Messeinrichtung
- 110: Messsystem
- L1: erster Außenleiter; erste Phase
- L2: zweiter Außenleiter; zweite Phase
- L3: dritter Außenleiter; dritte Phase
- K: Koppelrichtung (Pfeil)
- S: Kommunikationskanal (Doppelpfeil)
- T: Tragschiene; Hutschiene

## Patentansprüche

1. Messmodul (1) zum Messen zumindest einer Messgröße in einem Niederspannungsnetz, wobei das Messmodul (1) ein Modulgehäuse (10), zumindest einen Phasenkontakt (31,32,33) zum Anschließen an jeweils einen Außenleiter (L1,L2,L3) sowie zumindest einen Messsensor (20,21,22,23) zum Erfassen zumindest einer dem jeweiligen Außenleiter (L1,L2,L3) zuzurechnenden Messgröße umfasst, wobei für jeden Phasenkontakt (31,32,33) jeweils zumindest ein Funktionsindikator (11,12,13) vorgesehen ist,
wobei der jeweilige zumindest eine Funktionsindikator (11,12,13) am Modulgehäuse (10) angeordnet ist, und wobei die zumindest eine Messgröße ausgewählt ist aus einer Gruppe umfassend: elektrische Stromstärke, elektrische Spannung, elektrische Leistung, Ohmscher Widerstand, Energieverbrauch, Leistungsfaktor, Wirkfaktor, Temperatur eines elektrischen Kontaktes; und wobei das Messmodul (1) zur Erfassung von zwei oder mehreren Messgrößen ausgestattet ist, die vorzugsweise simultan erfassbar sind,
**dadurch gekennzeichnet,**
**dass** das Messmodul (1) dazu eingerichtet ist, den jeweiligen zumindest einen Funktionsindikator (11,12,13) in Abhängigkeit von der zumindest einen erfassten Messgröße anzusteuern und wahlweise ein Überschreiten oder ein Unterschreiten zumindest eines Grenzwerts der zumindest einen zu erfassenden Messgröße als Fehlersignal (14) mittels des jeweiligen zumindest einen Funktionsindikators (11, 12, 13) anzuzeigen, und
**dass** das Messmodul (1) dazu eingerichtet ist, dass die Ansteuerung des jeweiligen zumindest einen Funktionsindikators (11,12,13) derart parametrierbar ist, dass der zumindest eine Grenzwert der zumindest einen zu erfassenden Messgröße einstellbar vordefiniert ist.

2. Messmodul (1) nach Anspruch 1, **dadurch gekennzeichnet, dass** zumindest zwei Phasenkontakte (31,32,33) vorgesehen sind, wobei die zumindest zwei Phasenkontakte (31,32,33) einen ersten Phasenkontakt (31) zum Anschließen eines ersten Außenleiters (L1) sowie einen zweiten Phasenkontakt (32) zum Anschließen eines zweiten Außenleiters (L2) umfassen, und wobei dem ersten Phasenkontakt (31) zumindest ein am Modulgehäuse (10) angeordneter erster Funktionsindikator (11) sowie dem zweiten Phasenkontakt (32) zumindest ein am Modulgehäuse (10) angeordneter zweiter Funktionsindikator (12) zugeordnet sind.

3. Messmodul (1) nach Anspruch 1 oder 2, **dadurch gekennzeichnet, dass** drei Phasenkontakte (31,32,33), bestehend aus einem ersten Phasenkontakt (31), einem zweiten Phasenkontakt (32) und einem dritten Phasenkontakt (33), vorgesehen sind, wobei der erste Phasenkontakt (31) zum Anschließen eines ersten Außenleiters (L1), der zweite Phasenkontakt (32) zum Anschließen eines zweiten Außenleiters (L2) und der dritte Phasenkontakt (33) zum Anschließen eines dritten Außenleiters (L3) dienen, und wobei dem ersten Phasenkontakt (31) zumindest ein am Modulgehäuse (10) angeordneter erster Funktionsindikator (11), dem zweiten Phasenkontakt (32) zumindest ein am Modulgehäuse (10) angeordneter zweiter Funktionsindikator (12) sowie dem dritten Phasenkontakt (33) zumindest ein am Modulgehäuse (10) angeordneter dritter Funktionsindikator (13) zugeordnet sind.

4. Messmodul (1) nach einem der Ansprüche 1 bis 3, **dadurch gekennzeichnet, dass** der zumindest eine Funktionsindikator (11,12,13) je Phasenkontakt (31,32,33) eine LED-Signalleuchte, vorzugsweise eine zweifarbig oder mehrfarbig umschaltbare LED-Signalleuchte, umfasst.

5. Messmodul (1) nach einem der Ansprüche 1 bis 4, **dadurch gekennzeichnet, dass** zumindest zwei Funktionsindikatoren (11,12,13) je Phasenkontakt (31,32,33) vorgesehen sind, wobei die zumindest zwei Funktionsindikatoren (11,12,13) vorzugsweise jeweils als LED-Signalleuchten, besonders bevorzugt als zweifarbig oder mehrfarbig umschaltbare LED-Signalleuchten, ausgeführt sind.

6. Messmodul (1) nach einem der Ansprüche 1 bis 5, **dadurch gekennzeichnet, dass** das Modulgehäuse (10) zumindest ein Befestigungselement (15) aufweist, wobei das zumindest eine Befestigungselement (15) vorzugsweise eine Befestigungsöse und/oder eine Gehäuseausnehmung (16) ist oder umfasst.

7. Messeinrichtung (100) mit zumindest einem Messmodul (1), vorzugsweise mit mehreren Messmodulen (1), nach einem der Ansprüche 1 bis 6 sowie mit einem Kommunikationsmodul (6), wobei das Kommunikationsmodul (6) ein Gehäuse (60) aufweist und signaltechnisch mittels eines, insbesondere drahtlosen, Kommunikationskanals (S) mit dem zumindest einen Messmodul (1) gekoppelt ist, wobei das zumindest eine Messmodul (1) eine Schnittstelle (38) zur Übergabe von vom zumindest einen Messsensor (20,21,22,23) erfassten digitalen Messdaten an das Kommunikationsmodul (6) aufweist, und wobei das Kommunikationsmodul (6) einen Datenspeicher zum Speichern der digitalen Messdaten aufweist.

8. Messeinrichtung (100) nach Anspruch 7, **dadurch gekennzeichnet, dass** das Kommunikationsmodul (6) ein mobiles Endgerät (7), vorzugsweise ein Smartphone und/oder einen Notebook-Rechner, umfasst oder ein mobiles Endgerät (7) ist.

9. Messeinrichtung (100) nach einem der Ansprüche 7 oder 8, **dadurch gekennzeichnet, dass** das zumindest eine Messmodul (1) im Gehäuse (60) des Kommunikationsmoduls (6) integriert ist, oder das zumindest eine Messmodul (1) und das Kommunikationsmodul (6) dazu eingerichtet sind, um zumindest ein Modulgehäuse (10) mit dem Gehäuse (60) des Kommunikationsmoduls (6) lösbar koppeln (K) zu können.

10. Messsystem (110) mit zumindest einem Messmodul (1), vorzugsweise mit mehreren Messmodulen (1), nach einem der Ansprüche 1 bis 6, oder mit einer Messeinrichtung (100) nach einem der Ansprüche 7 bis 9, das Messsystem (110) weiterhin umfassend einen Lasttrennschalter (5), wobei der Lasttrennschalter (5) ein Schaltergehäuse (50), zumindest eine Phasenklemme (51,52,53) zum Anschließen an jeweils einen Außenleiter (L1,L2,L3) sowie zumindest eine Schalterklemme (51.1,52.2,53.3) zum Anschließen an jeweils eine weiterführende Leitung aufweist und dazu eingerichtet ist, eine elektrische Verbindung zwischen der zumindest einen Phasenklemme (51,52,53) und der zumindest einen Schalterklemme (51.1,52.1,53.1) wahlweise ein- oder auszuschalten, wobei der zumindest eine Phasenkontakt (31,32,33) des zumindest einen Messmoduls (1) komplementär zur zumindest einen Phasenklemme (51,52,53) und/oder zur zumindest einen Schalterklemme (51.1,52.1,53.1) des Lasttrennschalters (5) geformt ist, um in der zumindest einen Phasenklemme (51,52,53) oder Schalterklemme (51.1,52.1,53.1) mitgeklemmt werden zu können.

11. Messsystem (110) nach Anspruch 10, **dadurch gekennzeichnet, dass** das zumindest eine Messmodul (1) im Schaltergehäuse (50) des Lasttrennschalters (5) integriert ist, oder zumindest ein Messmodul (1) und der Lasttrennschalter (5) dazu eingerichtet sind, um zumindest ein Modulgehäuse (10) mit dem Schaltergehäuse (50) des Lasttrennschalters (5) lösbar koppeln (K) zu können.

12. Niederspannungsverteiler mit zumindest einem Messmodul (1), vorzugsweise mit mehreren Messmodulen (1), nach einem der Ansprüche 1 bis 6, oder mit einer Messeinrichtung (100) nach einem der Ansprüche 7 bis 9, oder mit einem Messsystem (110) nach einem der Ansprüche 10 oder 11.

## Claims

1. Measuring module (1) for measuring at least one measured variable in a low-voltage network, wherein the measuring module (1) comprises a module housing (10), at least one phase contact (31, 32, 33) for connection to a respective line conductor (L1, L2, L3) and at least one measuring sensor (20, 21, 22, 23) for detecting at least one measured variable attributable to the respective line conductor (L1, L2, L3), wherein at least one function indicator (11, 12, 13) is provided for each phase contact (31, 32, 33), wherein the respective at least one function indicator (11, 12, 13) is arranged on the module housing (10), and wherein the at least one measured variable is selected from a group comprising: electrical current, electrical voltage, electrical power, ohmic resistance, energy consumption, power factor, efficiency factor, temperature of an electrical contact; and wherein the measuring module (1) is equipped for detecting two or more measured variables, which can preferably be detected simultaneously, **characterized in that**
the measuring module (1) is set up to control the respective at least one function indicator (11, 12, 13) as a function of the at least one detected measured variable and to selectively indicate an overshoot or undershoot of at least one limit value of the at least one measured variable to be detected as an error signal (14) by means of the respective at least one function indicator (11, 12, 13), and
**in that** the measuring module (1) is set up such that the actuation of the respective at least one function indicator (11, 12, 13) can be parameterized such that the at least one limit value of the at least one measured variable to be detected is predefined in an adjustable manner.

2. Measuring module (1) according to claim 1, **characterized in that** at least two phase contacts (31, 32, 33) are provided, wherein the at least two phase contacts (31, 32, 33) comprise a first phase contact (31) for connecting a first line conductor (L1) and a second phase contact (32) for connecting a second line conductor (L2), and wherein at least one first functional indicator (11) arranged on the module housing (10) is assigned to the first phase contact (31) and at least one second functional indicator (12) arranged on the module housing (10) is assigned to the second phase contact (32).

3. Measuring module (1) according to claim 1 or 2, **characterized in that** three phase contacts (31, 32, 33), consisting of a first phase contact (31), a second phase contact (32) and a third phase contact (33), are provided, wherein the first phase contact (31) is used to connect a first line conductor (L1), the second phase contact (32) is used to connect a second line conductor (L2) and the third phase contact (33) is used to connect a third line conductor (L3), and wherein at least one first function indicator (11) arranged on the module housing (10) is assigned to the first phase contact (31), at least one second function indicator (12) arranged on the module housing (10) is assigned to the second phase contact (32) and at least one third function indicator (13) arranged on the module housing (10) is assigned to the third phase contact (33).

4. Measuring module (1) according to one of claims 1 to 3, **characterized in that** the at least one function indicator (11, 12, 13) for each phase contact (31, 32, 33) comprises an LED signal light, preferably a two-color or multi-color switchable LED signal light.

5. Measuring module (1) according to one of claims 1 to 4, **characterized in that** at least two function indicators (11, 12, 13) are provided for each phase contact (31, 32, 33), wherein the at least two function indicators (11, 12, 13) are preferably each designed as LED signal lights, particularly preferably as two-color or multi-color switchable LED signal lights.

6. Measuring module (1) according to one of claims 1 to 5, **characterized in that** the module housing (10) has at least one fastening element (15), wherein the at least one fastening element (15) preferably is or comprises a fastening eyelet and/or a housing recess (16).

7. Measuring device (100) having at least one measuring module (1), preferably having a plurality of measuring modules (1), according to one of claims 1 to 6 and having a communication module (6), wherein the communication module (6) has a housing (60) and is coupled via signaling to the at least one measuring module (1) by means of a communication channel (5), in particular a wireless communication channel (5), wherein the at least one measuring module (1) has an interface (38) for transferring digital measurement data recorded by the at least one measurement sensor (20, 21, 22, 23) to the communication module (6), and wherein the communication module (6) has a data memory for storing the digital measurement data.

8. Measuring device (100) according to claim 7, **characterized in that** the communication module (6) comprises a mobile terminal device (7), preferably a smartphone and/or a notebook computer, or is a mobile terminal device (7).

9. Measuring device (100) according to one of claims 7 or 8, **characterized in that** the at least one measuring module (1) is integrated in the housing (60) of the communication module (6), or the at least one measuring module (1) and the communication module (6) are set up so that at least one module housing (10) can be detachably coupled (K) to the housing (60) of the communication module (6).

10. Measuring system (110) having at least one measuring module (1), preferably having a plurality of measuring modules (1), according to one of claims 1 to 6, or having a measuring device (100) according to one of claims 7 to 9, wherein the measuring system (110) further comprises a load-break switch (5), wherein the load-break switch (5) has a switch housing (50), at least one phase terminal (51, 52, 53) for connection to a respective line conductor (L1, L2, L3) and at least one switch terminal (51.1, 52.2, 53.3) for connection to one respective continuing line and is set up for the purpose of selectively switching on or off an electrical connection between the at least one phase terminal (51, 52, 53) and the at least one switch terminal (51.1, 52.1, 53.1), wherein the at least one phase contact (31, 32, 33) of the at least one measuring module (1) is shaped complementary to the at least one phase terminal (51, 52, 53) and/or to the at least one switch terminal (51.1, 52.1, 53.1) of the load-break switch (5) in order to be able to be clamped in the at least one phase terminal (51, 52, 53) or switch terminal (51.1, 52.1, 53.1).

11. Measuring system (110) according to claim 10, **characterized in that** the at least one measuring module (1) is integrated in the switch housing (50) of the load-break switch (5), or at least one measuring module (1) and the load-break switch (5) are set up so that at least one module housing (10) can be detachably coupled (K) to the switch housing (50) of the load-break switch (5).

12. Low-voltage distribution board having at least one measuring module (1), preferably having a plurality of measuring modules (1), according to one of claims 1 to 6, or having a measuring device (100) according to one of claims 7 to 9, or having a measuring system (110) according to one of claims 10 or 11.

## Revendications

1. Module de mesure (1) pour la mesure d'au moins une grandeur de mesure dans un réseau sous basse tension, lequel module de mesure (1) comprend un boîtier de module (10), au moins un contact de phase (31, 32, 33) pour le raccordement à un conducteur extérieur (L1, L2, L3) correspondant et au moins un capteur de mesure (20, 21, 22, 23) pour l'acquisition d'au moins une grandeur de mesure attribuable au conducteur extérieur (L1, L2, L3) en question, dans lequel au moins un indicateur de fonctionnement (11, 12, 13) est prévu pour chaque contact de phase (31, 32, 33), l'au moins un indicateur de fonctionnement (11, 12, 13) respectif étant disposé sur le boîtier de module (10), et dans lequel l'au moins une grandeur de mesure est choisie parmi un groupe comprenant intensité électrique, tension électrique, puissance électrique, résistance ohmique, consommation d'énergie, facteur de puissance, facteur de puissance active, température d'un contact électrique, le module de mesure (1) étant équipé pour acquérir deux ou plusieurs grandeurs de mesure qui peuvent de préférence être acquises simultanément, **caractérisé en ce que** le module de mesure (1) est configuré pour commander l'au moins un indicateur de fonctionnement (11, 12, 13) en question en fonction de l'au moins une grandeur de mesure acquise et pour signaler par un signal d'erreur (14) au moyen de l'au moins un indicateur de fonctionnement (11, 12, 13) en question que l'au moins une grandeur de mesure à acquérir soit dépasse, soit est inférieure à au moins une limite, et
**en ce que** le module de mesure (1) est configuré de telle façon que l'activation de l'au moins un indicateur de fonctionnement (11, 12, 13) en question soit paramétrable de sorte que l'au moins une limite de l'au moins une grandeur de mesure à acquérir soit prédéfinie de façon réglable.

2. Module de mesure (1) selon la revendication 1, **caractérisé en ce qu'**au moins deux contacts de phase (31, 32, 33) sont prévus, les au moins deux contacts de phase (31, 32, 33) comprenant un premier contact de phase (31) pour le raccordement d'un premier conducteur extérieur (L1) et un deuxième contact de phase (32) pour le raccordement d'un deuxième conducteur extérieur (L2), et le premier contact de phase (31) étant associé au moins à un premier indicateur de fonctionnement (10) disposé sur le boîtier de module (10) et le deuxième contact de phase (32) au moins à un deuxième indicateur de fonctionnement (12) disposé sur le boîtier de module (10).

3. Module de mesure (1) selon la revendication 1 ou 2, **caractérisé en ce que** sont prévus trois contacts de phase (31, 32, 33), composés d'un premier contact de phase (31), d'un deuxième contact de phase (32) et d'un troisième contact de phase (33), le premier contact de phase (31) servant au raccordement d'un premier conducteur extérieur (L1), le deuxième contact de phase (32) au raccordement d'un deuxième conducteur extérieur (L2) et le troisième contact de phase (33) au raccordement d'un troisième conducteur extérieur (L3), et le premier contact de phase (31) étant associé au moins à un premier indicateur de fonctionnement (11) disposé sur le boîtier de module (10), le deuxième contact de phase (32) à au moins un deuxième indicateur de fonctionnement (12) disposé sur le boîtier de module (10) et le troisième contact de phase (33) à au moins un troisième indicateur de fonctionnement (13) disposé sur le boîtier de module (10).

4. Module de mesure (1) selon l'une des revendications 1 à 3, **caractérisé en ce que** l'au moins un indicateur de fonctionnement (11, 12, 13) comprend pour chaque contact de phase (31, 32, 33) un témoin lumineux à DEL, de préférence un témoin lumineux à DEL commutable à deux ou plusieurs couleurs.

5. Module de mesure (1) selon l'une des revendications 1 à 4, **caractérisé en ce qu'**au moins deux indicateurs de fonctionnement (11, 12, 13) sont prévus pour chaque contact de phase (31, 32, 33), les au moins deux indicateurs de fonctionnement (11, 12, 13) étant de préférence réalisés chacun comme un témoin lumineux à DEL, de préférence particulièrement un témoin lumineux à DEL commutable à deux ou plusieurs couleurs.

6. Module de mesure (1) selon l'une des revendications 1 à 5, **caractérisé en ce que** le boîtier de module (10) comporte au moins un élément de fixation (15), l'au moins un élément de fixation (15) étant ou comprenant de préférence un œillet de fixation et/ou un creux du boîtier (16).

7. Installation de mesure (100) munie d'au moins un module de mesure (1), de préférence de plusieurs modules de mesure (1), selon l'une des revendications 1 à 6 et d'un module de communication (6), dans laquelle le module de communication (6) comporte un boîtier (60) et est couplé avec l'au moins un module de mesure (1) pour la transmission de signaux au moyen d'un canal de communication (S), en particulier sans fil, l'au moins un module de mesure (1) comportant une interface (38) pour le transfert de données de mesure numériques acquises par l'au moins un capteur de mesure (20, 21, 22, 23) au module de communication (6) et le module de communication (6) comportant une mémoire de données pour le stockage des valeurs de mesure numériques.

8. Installation de mesure (100) selon la revendication 7, **caractérisée en ce que** le module de communication (6) comprend un terminal mobile (7), de préférence un smartphone et/ou un ordinateur de type *notebook,* ou est un terminal mobile (7).

9. Installation de mesure (100) selon l'une des revendications 7 ou 8, **caractérisée en ce que** l'au moins un module de mesure (1) est intégré dans le boîtier (60) du module de communication (6) ou l'au moins un module de mesure (1) et le module de communication (6) sont configurés pour pouvoir coupler (K) de façon amovible au moins un boîtier de module (10) avec le boîtier (60) du module de communication (6).

10. Système de mesure (110) muni d'au moins un module de mesure (1), de préférence de plusieurs modules de mesure (1), selon l'une des revendications 1 à 6, ou muni d'une installation de mesure (100) selon l'une des revendications 7 à 9, lequel système de mesure (110) comprend en outre un sectionneur de charge (5), le sectionneur de charge (5) comportant un boîtier de commutateur (50), au moins une borne de phase (51, 52, 53) pour le raccordement à un conducteur extérieur (L1, L2, L3) correspondant et au moins une borne de commutateur (51.1, 52.2, 53.3) pour le raccordement à une ligne sortante correspondante et est configuré de façon à établir ou couper sélectivement une connexion électrique entre l'au moins une borne de phase (51, 52, 53) et l'au moins une borne de commutateur (51.1, 52.1, 53.1), l'au moins un contact de phase (31, 32, 33) de l'au moins un module de mesure (1) ayant une forme complémentaire de l'au moins une borne de phase (51, 52, 53) et/ou de l'au moins une borne de commutateur (51.1, 52.1, 53.1) du sectionneur de charge (5) afin de pouvoir être serré lui aussi dans l'au moins une borne de phase (51, 52, 53) ou borne de commutateur (51.1, 52.1, 53.1).

11. Système de mesure (110) selon la revendication 10, **caractérisé en ce que** l'au moins un module de mesure (1) est intégré dans le boîtier de commutateur (50) du sectionneur de charge (5), ou l'au moins un module de mesure (1) et le sectionneur de charge (5) sont configurés pour pouvoir coupler (K) de façon amovible au moins un boîtier de module (10) au boîtier de commutateur (50) du sectionneur de charges (5).

12. Répartiteur basse tension muni d'au moins un module de mesure (1), de préférence de plusieurs modules de mesure (1), selon l'une des revendications 1 à 6 ou d'une installation de mesure (100) selon l'une des revendications 7 à 9 ou d'un système de mesure (110) selon l'une des revendications 10 ou 11.
